Europäisches Patentamt

(19) European Patent Office

Office européen des brevets

(11) Publication number: **0 232 614**

**A1**

## (12) EUROPEAN PATENT APPLICATION

(21) Application number: **86309950.3**

(22) Date of filing: **19.12.86**

(51) Int. Cl.⁴: **G01R 1/067**

(30) Priority: **30.12.85 US 814857**

(43) Date of publication of application:
**19.08.87 Bulletin 87/34**

(84) Designated Contracting States:
**DE FR GB NL**

(71) Applicant: **TEKTRONIX, INC.**
**Tektronix Industrial Park D/S Y3-121 4900**
**S.W. Griffith Drive P.O. Box 500**
**Beaverton Oregon 97077(US)**

(72) Inventor: **Janko, Bozidar**
**2180 S.W. Sunset Drive Portland Drive**
**Portland Oregon 97201(US)**

(74) Representative: **Baillie, Iain Cameron et al**
**c/o Ladas & Parry Isartorplatz 5**
**D-8000 München 2(DE)**

(54) **Electronic probe.**

(57) An electronic probe assembly having a sharp metal probe tip and a pair of retractable legs forming a tripod for supporting the probe above a planar circuit board. A weight in the probe body facilitates effective contact of the probe tip with a circuit element being tested and helps prevent slippage of the unattended probe.

FIG. 2

EP 0 232 614 A1

## ELECTRONIC PROBE

### Background of the Invention

The present invention relates to measurement devices for electrical circuits and particularly to probes for making direct, temporary contact to selected points on generally planar circuit elements.

Conventional electronic probes are hand-held devices used to provide temporary electrical connections between test equipment and selected points, usually leads of a circuit package mounted on a planar circuit board, or test points on the board between the packages. Circuit elements and interconnect leads are becoming progressively smaller and more crowded due to continued advances in integrated circuit and packaging technology; consequently, the use of hand-held probes to test circuit board assemblies requires increased dexterity and care to prevent short circuits. Undue attention is required on the part of the technician who would prefer to have his hands free for other tasks.

Conventional electronic probes are rod-like instruments that may be provided with a variety of tips for differing testing environments, e.g., a sharp, slender, pointed-metal tip can be used to probe small circuit elements such as package leads; however, the probe must be held in the user's hand. Other probes are provided with hook tips to allow hanging the probe from a circuit element; however, the proximity of adjacent circuit elements often precludes their use because of the ease with which the adjacent elements may be short circuited by the probe tip. Further, conventional probe bodies are light-weight devices, weighing, for example, from 10 to 15 grams, and a probe hooked to a circuit element can easily become loose, particularly if the probe cable is disturbed. Hook-tip probes may be spring loaded to allow grasping a lead or circuit element positively, but delicate components can be easily bent or damaged by levered force applied thereto.

In view of the foregoing, it is an object of the invention to provide an improved electronic probe.

Another object of the invention is to provide an improved electronic probe that facilitates testing of modern microcircuits.

It is another object of the invention to provide an improved electronic probe for probing miniature circuit elements, surface-mounted on a generally planar circuit board or substrate.

Still another object of the invention is to provide an improved electronic probe which may be easily positioned on a test point and left without being held in place by hand.

Another object of the invention is to provide an improved electronic probe that positively contacts a test point with controlled force.

### Summary

In accordance with one aspect of the invention, an elongate electronic probe is provided with a probing tip extending from one end of the probe, and a pair of optionally retractable legs, spaced apart and extending laterally from the other end of the probe body in the same general direction as the tip, thereby providing a tripod-like configuration for standing the probe unattended on, and oriented generally parallel with, a horizontally disposed device to be tested. In accordance with another aspect of the invention, a weight is provided in the body of the probe to ensure solid contact of the tip with a point being tested and to preclude inadvertent movement of the unattended probe.

### Drawings

While the invention is set forth with particularity in the appended claims, other objects, features, the organization and method of operation of the invention will become more apparent, and the invention will best be understood by referring to the following detailed description in conjunction with the accompanying drawings in which:

FIG. 1 is a block and schematic representation of an electronic probe in accordance with the present invention;

FIG. 2 is a perspective view of an electronic probe in accordance with the instant invention;

FIG. 3 is a modified longitudinal section view of the electronic probe of FIG. 2;

FIG. 4 illustrates a probe in accordance with the invention as placed on a circuit board;

FIG. 5 illustrates the manner in which microindentations are formed at test points by the probe of the instant invention; and

FIG. 6 is a broken-away, perspective view of a probe illustrating an alternative embodiment in accordance with the invention.

## Description of the Preferred Embodiment

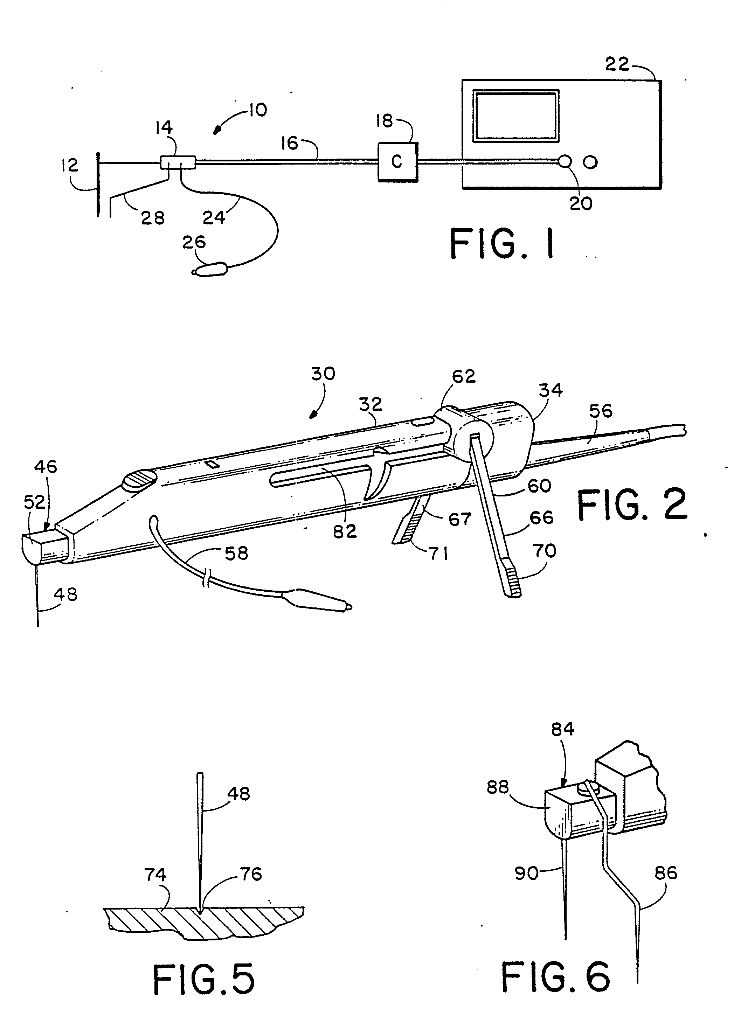

Referring now to the drawings for a more detailed description of the construction, operation and other features of the invention by characters of reference, FIG. 1 illustrates schematically an electronic probe 10 having a probing tip or needle 12 connected through an attenuator circuit 14 to a probe cable 16. The cable 16 conducts an attenuated signal from a test point contacted by the probe tip 12 through a compensation circuit 18 to an input terminal 20 of a test instrument 22, which may comprise an oscilloscope. A ground lead 24, having suitable means such as an alligator clip 26 for connecting a grounding circuit of the probe to a ground terminal of the circuit under test, emanates from the probe 10. Alternatively, a ground contact 28 proximate the tip 12 may be attached to the probe 10. Although the invention is described herein with reference to a passive voltage probe, other kinds of probes, both active and passive, may incorporate the features of the instant invention, e.g. the probe may comprise a temperature probe. While the purpose of an electronic probe is usually to conduct a signal from the probe tip to a test instrument, the electronic characteristics of the various kinds probes are not germane to the present invention, and therefore details relating to such characteristics are disclosed herein only insofar as they affect the construction and operation according to the invention.

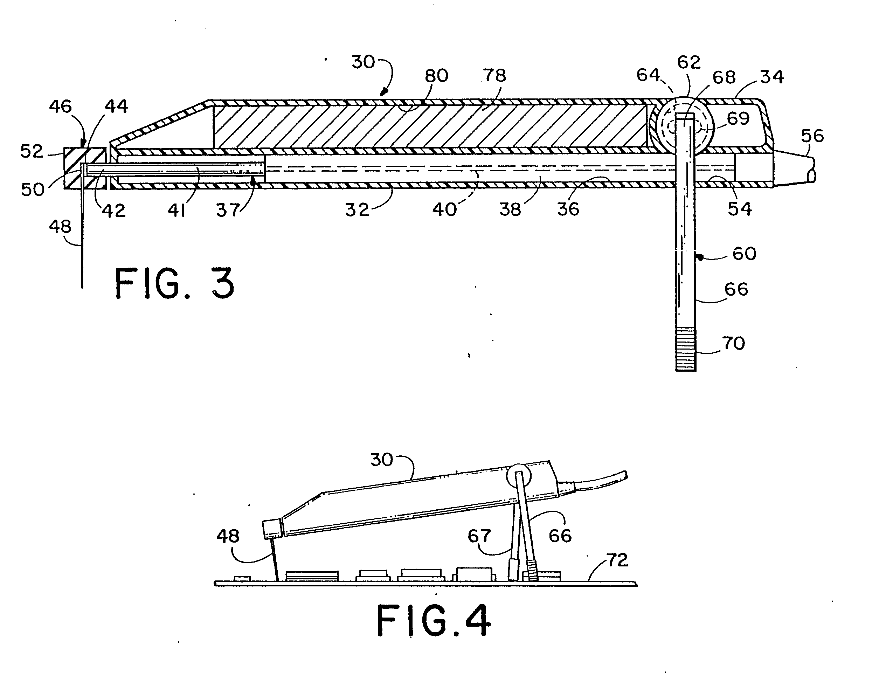

Referring to FIGS. 2 and 3, an electronic probe 30 has an elongate body 32 with an end piece 34, both formed of an insulative plastic material such as nylon or polycarbonate. A cylindrical cavity 36 provided within the body 32 receives electrical components of the probe including attenuator assembly 37 and a cylindrical ground shield 38 having the central conductor 40 of the probe disposed coaxially therewithin. The attenuator assembly 37 is suitably contained in a housing 41 made of a rigid, nonconductive material, one end 42 of which protrudes longitudinally from the body 32 of the probe. A conductive pad 44, part of the probe circuit, is disposed at the forward end 42 of the attenuator assembly housing.

The protruding end of the housing 41 provides a means for mounting a probe tip assembly 46 on the probe 30. The tip assembly 46, comprising a sharp, metal contacting pin 48, extends laterally from the probe 30 (with respect to its longitudinal direction) and makes electrical contact with pad 44 at the root end 50 of the pin 48. The pin 48 is preferably made from a hard metal, suitably tungsten carbide, but may also be made from a more flexible and ductile material such as type 302 stainless steel. Root end 50 of the pin 48 is suitably housed in a rigid, nonconductive plastic cap 52 which slips engagably onto the end 42 of the attenuator assembly housing 41.

The ground shield 38 extends from the cavity 36 into a cylindrical cavity 54 formed in the end piece 34, where the central conductor 40 and the shield 38 are connected to a cable 56. A conventional ground lead 58 may be clipped to the probe.

A leg assembly 60 of the probe 30 comprises a pivot member 62 rotatably mounted posteriorly of the probe body 32 in a cylindrical cavity 64 formed between the body 32 and the end piece 34. A pair of legs 66, 67 are attached, inside the pivot member 62 at either end thereof, such that, when extended, the legs 66, 67 are disposed outwardly from the body of the probe 30 in a V-configuration. The apex 68 of the V is located at pivot member 62 as illustrated in FIG. 3. Legs 66, 67 and the pivot 62 are suitably formed from a resilient nonconductive plastic material, preferably polycarbonate, with the legs 66, 67 including protrusions or bosses 69 received in sockets formed in pivot member 62, as by press fitting, to enable pivotal movement of the legs about the probe body. End pieces or boots 70, 71, made from a soft, non-slip material such as polyvinyl chloride or rubber, are affixed to the extended ends of the legs 66, 67 to inhibit movement of the legs with respect to a circuit board or other surface upon which they may be resting.

The legs 66, 67 and the pin 48 form three legs of a tripod probe assembly in accordance with the instant invention. Referring to FIGS. 4 and 5, the probe 30 may be placed on a circuit assembly such as a printed circuit board 72 having surface mounted packages and components, the tip 48 contacting and adhering to a component lead or test point 74, as illustrated in FIG. 5, even with the probe 30 left unattended. The tripod configuration procures a solid, weighted electrical connection, with stable but limited three point support of the probe from the circuit board. The tip 48, being sharply pointed and made from a hard metal, is capable of making microindentations in the softer metals from which leads and circuit runs are made. The weight of the probe concentrates a comparatively large pressure at the point of pin 48. FIG. 5 illustrates such a microindentation 76 in a surface of the test point 74. With the probe pin 48 engaging the microindentation 76, the tendency for the probe to tip or slide off the test point 74 is minimized. It is further noted the probe body forms a lever, with a comparatively long lever arm length substantially equaling the length of the probe body, rotatable about the fulcrum formed by the tips of legs 66, 67.

Referring to FIG. 3, to further facilitate solid contact and effective lever action of the tripod electronic probe 30 on a planar circuit board, a substantial additional weight 78 is housed in a second cavity 80 formed in the body 32 of the probe 30 substantially for the length thereof nearly up to the forward tip. In the presently described embodiment of the invention, the weight 78 is comprised of twenty-eight grams of lead, making the total weight of the probe assembly 30, exclusive of the cable assembly 56, about forty-two grams. The added lead weight 78, combined with the needle-sharp point 48, the lever action of the body, and the non-slip leg boots 70, 71, virtually eliminates the tendency for the unattended probe to move or to be accidently urged out of position, even when the cable 56 is inadvertently contacted or its position adjusted. It is noted that the torque of the cable around the fulcrum comprising the legs 66, 67 is not sufficient to overcome the moment provided in accordance with the elongated probe body, the probe-body weight and needle-sharp point, keeping the probe in place.

The pivot 62 and the legs 66, 67 may be rotated clockwise (with respect to body 32, as illustrated) for aligning the legs with grooves 82 formed exteriorly on sides of the probe body 32. When so aligned, the legs 66, 67 can also be pivoted inwardly toward the probe body and retracted into the grooves 82 for storage, whereupon the probe 30 may be handled as a conventional probe.

Referring to FIG. 6, an alternate embodiment of the probe assembly is illustrated having a tip assembly 84 including a ground pin or conductor 86 pivotally mounted to a cap 88. The ground pin 86 may be manually repositioned rotationally with respect to signal pin 90, and, in use, is elastic with respect thereto. Various configurations, i.e., shapes of the ground pin 86, may be provided on removable cap assemblies to vary the distance between the signal pin 90 and ground pin 86. The ground conductor 86 is connected internally of the cap 88 to signal ground.

The tip of the probe may alternatively comprise a temperature sensing element such as a thermocouple wherein the tip contacting the test point is substantially flat and is about one to three millimeters across. A thermally conducting paste may in such case be applied to the thermocouple tip to aid in maintaining non-slip contact between the test point and the tip.

While the principles of the invention have been made clear in an illustrative embodiment, there will be apparent to those skilled in the art many modifications of structure, arrangement, proportions, the elements, material and components used in the practice of the invention, and otherwise, which are particularly adapted for specific environments and operating requirements, without departing from those principles. The appended claims are intended to cover and embrace any such modifications, within the limits only of the scope of the invention.

## Claims

1. An electronic probe, comprising:
a probe body;
a probe tip extending from the body for contacting a surface-mounted element to be tested, said probe tip forming one leg supporting said body; and
two other legs forming a tripod with said probe tip, said tripod supporting said probe body above said surface-mounted element.

2. The electronic probe of claim 1, wherein said other legs are retractable into said probe body.

3. The electronic probe of claim 1 further comprising a pivot rotatably mounted in said probe body, said other legs being pivotally attached to said pivot in an inverted V-shaped configuration, said other legs being rotatable in two planes for retraction into said probe body.

4. The electronic probe of claim 1 further comprising a weight on said probe body, said weight bearing on said probe tip for increasing the force with which said probe tip is urged toward said surface-mounted element.

5. The electronic probe of claim 4, wherein said probe body is an elongate element with said probe tip disposed toward one end of said probe body, wherein said other legs are disposed remotely along said elongate probe body, and wherein said weight is housed in said probe body between said probe tip and said other legs.

6. The electronic probe of claim 5, wherein probe tip extends laterally with respect to a longitudinal dimension from said probe body.

7. The electronic probe of claim 1 wherein said other legs include a non-skid tip surface.

8. The electronic probe of claim 1 wherein said probe tip comprises a sharp, hard-metal point.

9. A probe for testing circuit elements mounted on a surface, comprising:
a probe body;
means for supporting said probe body above the surface, said support means including means extending from said probe body for contacting an element to be tested; and
means for coupling a signal from said contacting means to a test instrument.

10. The probe of claim 9 further comprising means for engaging said contacting means into the element to be tested.

7     **0 232 614**     8

11. The probe of claim 10 wherein said engaging means comprises a sharply pointed hard metal tip of said contacting means.

12. The probe of claim 10 wherein said engaging means comprises a weight bearing on said contacting means.

13. The probe of claim 9 wherein said contacting means comprises a temperature sensing element.

14. The probe of claim 9 wherein said support means includes means extending from said probe body remotely from said contacting means for supporting said probe body at least at two points.

15. The probe of claim 14 wherein said support means comprises a tripod.

16. In a probe, at a forward end of said probe, first means for contacting a circuit board connection, said first means acting to provide a support for said probe,
means toward the rearward end of said probe for supporting said probe at least at two more points, and
means for coupling a signal from said first means to a testing instrument.

17. The probe according to claim 16 further comprising means for retracting said rearwardly disposed supporting means into said probe.

18. A method of making a test connection with a probe to a circuit board, comprising the steps of:
manually supporting the body of said probe on said circuit board at a first point on said probe while simultaneously making electrical contact with a test point of said circuit board at said first point, a signal from said contacted test point being coupled through said probe to a test instrument,
further stably supporting the body of said probe manually at second and third points on said circuit board removed from said first point, and
thereafter leaving said probe supported and unattended by removing hands from said probe.

19. The method of making an electrical connection from a probe to an electrical circuit board, comprising:
supporting the body of said probe on said circuit board at a first point on said probe while simultaneously making electrical contact with said electrical circuit at said first point,
further stably supporting the body of said probe at second and third points on said circuit board removed from said first point, and
coupling an electrical signal from said electrical circuit into said probe from said first point.

20. The method according to claim 19 further including weighting said probe between the location of said first point and the locus of said second and third points.

5

FIG. 1

FIG. 2

FIG.5

FIG. 6

FIG. 3

FIG.4

0 232 614

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-1 175 195 (VEB-ELEKTROMAT) <br><br> * complete document * | 1,9,18 ,19 | G 01 R 1/067 |
| A | | 2-8,10 -17,20 | |
| | --- | | |
| X | IBM TECHNICAL DISCLOSURE BULLETIN, vol. 23, no. 5, October 1980, page 1854; K.J. DESKUR et al.: "Stationary Self-Aligning Probe" <br> * page 1854 * | 1 | |
| | ----- | | |

|  | TECHNICAL FIELDS SEARCHED (Int. Cl.4) |
|---|---|
| | G 01 R 1/067 |

The present search report has been drawn up for all claims

| Place of search | Date of completion of the search | Examiner |
|---|---|---|
| BERLIN | 20-01-1987 | LEMMERICH J |